(19) Europäisches Patentamt
European Patent Office
Office européen des brevets

(11) **EP 2 901 534 B1**

(12) **EUROPÄISCHE PATENTSCHRIFT**

(45) Veröffentlichungstag und Bekanntmachung des Hinweises auf die Patenterteilung:
**21.04.2021 Patentblatt 2021/16**

(21) Anmeldenummer: **12801494.1**

(22) Anmeldetag: **26.11.2012**

(51) Int Cl.:
**H02H 3/28** *(2006.01)*

(86) Internationale Anmeldenummer:
**PCT/EP2012/073586**

(87) Internationale Veröffentlichungsnummer:
**WO 2014/079511 (30.05.2014 Gazette 2014/22)**

(54) **DIFFERENTIALSCHUTZVERFAHREN UND SCHUTZGERÄT ZUM DURCHFÜHREN EINES DIFFERENTIALSCHUTZVERFAHRENS**

DIFFERENTIAL PROTECTION METHOD AND PROTECTIVE DEVICE FOR CARRYING OUT A DIFFERENTIAL PROTECTION METHOD

PROCÉDÉ DE PROTECTION DIFFÉRENTIELLE ET APPAREIL DE PROTECTION SERVANT À METTRE EN UVRE UN PROCÉDÉ DE PROTECTION DIFFÉRENTIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.08.2015 Patentblatt 2015/32**

(73) Patentinhaber: **Siemens Aktiengesellschaft 80333 München (DE)**

(72) Erfinder: **MIESKE, Frank 13053 Berlin (DE)**

(56) Entgegenhaltungen:
**DE-A1- 2 339 931     US-A- 4 623 949**

- **DAVID C YU ET AL: "Correction of Current Transformer Distorted Secondary Currents Due to Saturation Using Artificial Neural Networks", IEEE TRANSACTIONS ON POWER DELIVERY, IEEE SERVICE CENTER, NEW YORK, NY, US, Bd. 16, Nr. 2, 1. April 2001 (2001-04-01), XP011050057, ISSN: 0885-8977**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf ein Differentialschutzverfahren zum Erzeugen eines Fehlersignals, bei dem an mindestens zwei unterschiedlichen Messstellen einer Komponente jeweils Strommesswerte gemessen werden, mit den Strommesswerten Differenzstromwerte und Stabilisierungswerte gebildet werden, und das Fehlersignal erzeugt wird, wenn im Rahmen einer Auslösebereichsprüfung festgestellt wird, dass ein unter Heranziehung eines der Differenzstromwerte und dem jeweils zugehörigen Stabilisierungswert gebildetes Messwertpaar in einem vorgegebenen Auslösebereich liegt. Die Erfindung bezieht sich auch auf ein entsprechendes elektrisches Schutzgerät zur Durchführung eines Differentialschutzverfahrens.

Schutzgeräte zur Durchführung eines Differentialschutzverfahrens werden zur Überwachung verschiedener Komponenteneelektrischer Energieversorgungsnetze, beispielsweise Leitungen, Sammelschienen und Transformatoren, eingesetzt. Dabei wird an mindestens zwei unterschiedlichen Messstellen der überwachten Komponente der an den Messstellen fließende Strom erfasst und in Form von Strommesswerten dem Schutzgerät zugeführt. Das Schutzgerät bildet durch vorzeichenrichtige Addition aus den Strommesswerten Differenzstromwerte, die zur Beurteilung der Betriebssituation der überwachten Komponente herangezogen werden. Im fehlerfreien Fall liegen der Differenzstromwerte in einem Bereich nahe Null, da hierbei - vereinfacht gesprochen - der in die Komponente hinein fließende Strom auch wieder aus ihr heraus fließt. Ergeben sich hingegen Differenzstromwerte, die deutlich von Null abweichen, so lassen diese auf einen fehlerbehafteten Betriebszustand, z.B. einen internen Kurzschluss, schließen, so dass der Fehlerstrom durch Öffnen von die Komponente begrenzenden Schalteinrichtungen, z.B. Leistungsschaltern, unterbrochen werden muss. Hierfür erzeugt das Schutzgerät ein entsprechendes Fehlersignal, das die Schalter zum Öffnen ihrer Schaltkontakte veranlasst.

Da in der Praxis keine idealen Verhältnisse, z.B. ein Differenzstrom im fehlerfreien Fall mit genau dem Wert Null, vorliegen, muss für den Differenzstrom ein geeigneter Vergleichswert gefunden werden. Hierfür wird der sogenannte Stabilisierungswert verwendet, der sich je nach Komponente unterschiedlich berechnet, beispielsweise ergibt sich beim Leitungsdifferentialschutz der Stabilisierungswert als Summe der Beträge der jeweiligen Strommesswerte. Trägt man einen Differenzstromwert und einen zugehörigen Stabilisierungswert in einem Auslösediagramm auf, so liegt das jeweilige Messwertpaar entweder innerhalb oder außerhalb eines festgelegten Auslösebereichs, so dass durch Auswertung der Lage des Messwertpaares auf die Bildung des Fehlersignals geschlossen werden kann: das Fehlersignal wird dann erzeugt, wenn das Messwertpaar innerhalb des vorgegebenen Auslösebereichs liegt.

Probleme ergeben sich hierbei beispielsweise dann, wenn einer oder mehrere der verwendeten Stromwandler, insbesondere bei transienten Bedingungen zu Beginn eines stromstarken internen oder externen Fehlers, in Sättigung gehen und der von ihnen abgegebenen sekundäre Stromverlauf keine korrekte Abbildung des primärseitigen Stromverlaufs darstellt. In solchen Fällen kann beispielsweise bei externen, also außerhalb der überwachten Komponente liegenden, Fehlern fälschlicherweise ein signifikanter Differenzstrom erkannt und damit ein Fehlersignal erzeugt werden, während andererseits bei internen, also die überwachte Komponente direkt betreffenden, Fehlern fälschlicherweise aufgrund eines zu geringen ermittelten Differenzstroms eine Bildung des Fehlersignals ausbleibt.

Ein Differentialschutzverfahren und ein entsprechendes Differentialschutzgerät der eingangs genannten Art sind beispielsweise aus der WO 2008/025309 A1 bekannt. Bei dem bekannten Differentialschutzgerät werden die an den unterschiedlichen Messstellen erfassten Stromverläufe hinsichtlich einer Ähnlichkeit überprüft und die Empfindlichkeit der Auslösung des Differentialschutzes entsprechend der erkannten Ähnlichkeit angepasst. Auf diese Weise kann erreicht werden, dass bei - z.B. durch Wandlersättigung - unähnlichen Stromverläufen die Empfindlichkeit des Differentialschutzgeräts entsprechend herabgesetzt wird, um nicht ungewollt ein Fehlersignal abzugeben.

Weitere Differentialschutzverfahren, bei denen eine etwaige Stromwandlersättigung bei der Erzeugung eines Fehlersignals berücksichtigt wird, sind beispielsweise aus der DE 23 39 931 A1 und der US 4,623,949 A bekannt.

Der Erfindung liegt die Aufgabe zugrunde, ein alternatives Verfahren bzw. Schutzgerät anzugeben, um auch im Falle einer auftretenden Wandlersättigung selektiv einen externen Fehler von einem internen Fehler zu unterscheiden und bei Vorliegen eines internen Fehlers mit hoher Sicherheit ein Fehlersignal zu erzeugen.

Diese Aufgabe wird erfindungsgemäß durch ein Verfahren gemäß Anspruch 1 gelöst, bei dem mindestens ein Teil der Differenzstromwerte und der Stabilisierungswerte mit während eines sättigungsfreien Zustands der Stromwandler zu Beginn eines Fehlers erfassten Strommesswerten gebildet werden, aus so gebildeten aufeinanderfolgenden Differenzstromwerten und zugehörigen Stabilisierungswerten abgeschätzte Differenzstromwerte und zugehörige abgeschätzte Stabilisierungswerte gebildet werden, mit denen zumindest ein Wert eines erwarteten zukünftigen Verlaufs der Differenzstromwerte und der Stabilisierungsstromwerte abgeschätzt wird, und für die Auslösebereichsprüfung die Lage eines aus einem abgeschätzten Differenzstromwert und dem jeweils zugehörigen abgeschätzten Stabilisierungswert gebildeten Messwertpaares ausgewertet wird.

Der Erfindung liegt die Erkenntnis zugrunde, dass auch in einer transienten Übergangsphase zu Beginn eines stromstarken internen oder externen Fehlers üblicherweise noch ein kurzer sättigungsfreier Zustand der Stromwandler vorliegt und die innerhalb dieser sättigungsfreien Zeit erfassten Strommesswerte folglich verlässlich den Zustand der überwachten Komponente abbilden. Werden nun auf Grundlage solcher verlässlicher Strommesswerte ermittelte Differenzstromwerte und Stabilisierungswerte dazu verwendet, um abgeschätzte Differenzstromwerte und Stabilisierungswerte zu bilden, die zumindest einen Wert eines erwarteten zukünftigen Verlaufs der Differenzstromwerte und Stabilisierungswerte abschätzen, so kann auf dieser Grundlage quasi ein Rückschluss auf zukünftige, während einer etwaigen Sättigungsphase vorliegende Werte der Differenzstromwerte und des Stabilisierungswerte gezogen werden. Werden diese abgeschätzten Werte für die Auslösebereichsprüfung verwendet, so kann hiermit auch bei etwaiger einsetzender Wandlersättigung eine Entscheidung darüber getroffen werden, ob ein interner oder ein externer Fehler vorliegt, so dass Fehlauslösungen durch eine Stromwandlersättigung vermieden werden.

Die Komponenten, für die das beschriebene Differentialschutzverfahren eingesetzt werden kann, können beliebig sein: Als Komponenten kommen beispielsweise Leitungen, Transformatoren, Sammelschienen, Netzanschnitte und dergleichen mehr in Betracht.

Die Differenzstromwerte werden aus den Strommesswerten durch vorzeichenrichtige Addition gebildet, während die Stabilisierungswerte komponentenspezifisch, d.h. unterschiedlich in Abhängigkeit von der Art der überwachten Komponente, gebildet werden: Beispielsweise werden im Falle einer Leitung oder einer Sammelschiene als überwachte Komponente zur Bildung der Stabilisierungswerte die Beträge der Strommesswerte aller Messstellen addiert, während im Falle eines Transformators als überwachte Komponente als Stabilisierungswert der RMS-Wert der Strommesswerte verwendet wird. Vorzugsweise werden bei mehrphasigen Komponenten die Strommesswerte an den Messstellen phasenweise erfasst und die Differenzstromwerte sowie Stabilisierungswerte entsprechend phasenweise gebildet.

Eine vorteilhafte Ausführungsform des erfindungsgemäßen Verfahrens sieht vor, dass zur Bildung eines jeweiligen abgeschätzten Differenzstromwertes jeweils der aktuelle Differenzstromwert und der diesem unmittelbar vorangehende Differenzstromwert und zur Bildung eines jeweiligen abgeschätzten Stabilisierungswertes jeweils der aktuelle Stabilisierungswert und der diesem unmittelbar vorangehende Stabilisierungswert verwendet werden.

Auf diese Weise kann sehr schnell nach Eintritt eines internen oder externen Fehlers, nämlich unter Verwendung lediglich zweier aufeinanderfolgender Strommesswerte (bzw. daraus gebildeter Differenzstromwerte und Stabilisierungswerte) eine Entscheidung über ein Vorliegen eines internen oder externen Fehlers getroffen werden. Insbesondere kann diese Entscheidung schneller getroffen werden als bei der Verwendung sogenannter RMS (root mean square) Werte der Differenzstromwerte und der Stabilisierungswerte, da für diese deutlich mehr Differenzstromwerte bzw. Stabilisierungswerte benötigt werden, bis sie eine verlässliche Abbildung der tatsächlichen Stromverläufe darstellen; bei auftretender Wandlersättigung liegen darüber hinaus oftmals nicht ausreichend viele Messwerte aus der sättigungsfreien Zeit vor, um zuverlässige RMS-Werte zu bilden.

Gemäß einer vorteilhaften Ausführungsform des erfindungsgemäßen Verfahrens kann in diesem Zusammenhang vorgesehen sein, dass die jeweiligen abgeschätzten Werte eine Amplitude des erwarteten zukünftigen Verlaufs der Differenzstromwerte und eine Amplitude des erwarteten zukünftigen Verlaufs der Stabilisierungswerte angeben.

Hierdurch kann bereits zu Beginn der transienten Übergangsphase beim Fehlereintritt mit der Amplitude ein jeweiliger Maximalwert der Differenzstromwerte und der Stabilisierungswerte abgeschätzt und zur Entscheidung über das Vorliegen eines internen oder externen Fehlers herangezogen werden.

Konkret kann in diesem Zusammenhang vorgesehen sein, dass der jeweilige abgeschätzte Differenzstromwert und der jeweilige abgeschätzte Stabilisierungswert jeweils unter Verwendung eines ersten, mittels eines Integriergliedes gebildeten Schätzwertanteils und eines zweiten, mittels eines Differenziergliedes gebildeten Schätzwertanteils gebildet werden.

Auf diese Weise können die abgeschätzten Werte unter Verwendung relativ einfacher mathematischer Operationen, nämlich einerseits durch Differenzieren (bzw. Bildung eines Differenzenquotienten) und andererseits durch Integrieren mit hinreichender Genauigkeit gebildet werden.

Konkret soll die Bildung der abgeschätzten Werte beispielhaft anhand der Amplitude der Stabilisierungswerte erläutert werden, die Vorgehensweise für die Differenzstromwerte ist entsprechend.

Die Amplitude Ä des zukünftigen erwarteten Verlaufs der Stabilisierungswerte wird unter Zugrundelegung eines im Wesentlichen sinusförmigen Signals gemäß der folgenden trigonometrischen Beziehung (1) gebildet:

$$\hat{A}^2 = \hat{A} \cdot \cos^2 \omega x + \hat{A} \cdot \sin^2 \omega x \qquad\qquad (1)$$

Hierbei steht Ä für die Amplitude des sinusförmigen Signals y=f(x) und ω für die Winkelgeschwindigkeit.

Da sich die 1. Ableitung eines periodischen sinusförmigen Signals y=Â · sinωx als y'=ωÂ · cosωx darstellen lässt, kann die obige Beziehung (1) in die folgende Form (2) überführt werden:

$$\hat{A} = \sqrt{y^2 + (y')^2} \qquad\qquad (2)$$

Der erste Schätzwertanteil y kann über ein Integrierglied anhand des aktuellen Wertes (k) und eines diesem unmittelbar vorausgehenden Wertes (k-1) des Verlaufs der Stabilisierungswerte $i_{Stab}$ ermittelt werden:

$$y(k) = F_{\text{int}} \cdot \left( i_{Stab}(k) + i_{Stab}(k-1) \right) \qquad (3)$$

Hierbei stellt $F_{\text{int}}$ einen Skalierungsfaktor dar, der das Tiefpassverhalten der Übertragungsfunktion des Integrierglieds berücksichtigt.

Da für im Verhältnis zur Netzperiode T sehr kleine Abtastabstände $T_A$, also der Zeitdauer, die bei der Erfassung des gemessenen Signals zwischen zwei Abtastwerten liegt, die 1. Ableitung y' als Differenzenquotient angenähert werden kann, wird der zweite Schätzwertanteil y' mittels eines Differenzierglieds als Differenzenquotient anhand des aktuellen Wertes (k) und des diesem unmittelbar vorausgehenden Wertes (k-1) des Verlaufs der Stabilisierungswerte $i_{Stab}$ ermittelt:

$$y'(k) = \frac{\Delta i_{Stab}}{\Delta t} = \frac{\Delta i_{Stab}}{T_A} = F_{dif} \cdot \left( i_{Stab}(k) - i_{Stab}(k-1) \right) \qquad (4)$$

Hierbei stellt $F_{dif}$ einen Skalierungsfaktor dar, der das Hochpassverhalten der Übertragungsfunktion des Differenzierglieds berücksichtigt.

Somit kann der abgeschätzte Wert für die Amplitude Ä des erwarteten zukünftigen Verlaufs der Stabilisierungswerte mit folgender Gleichung (5) gebildet werden:

$$\hat{A}(k) = \frac{1}{\sqrt{2}} \cdot \sqrt{\left( F_{\text{int}} \cdot \left( i_{Stab}(k) + i_{Stab}(k-1) \right) \right)^2 + \left( F_{dif} \cdot \left( i_{Stab}(k) - i_{Stab}(k-1) \right) \right)^2} \qquad (5)$$

Die Skalierungsfaktoren $F_{\text{int}}$ und $F_{dif}$ können wie folgt ermittelt werden:

Die Übertragungsfunktion $\hat{G}_{\text{int}}$ des Integrierglieds in diskreter Schreibweise kann als nichtrekursiver Tiefpass mit den Anteilen $a_0 = 1$ und $a_1 = 1$ angesehen werden:

$$\hat{G}_{\text{int}}(z) = a_0 + a_1 z^{-1} \qquad (6)$$

Mit

$$z^{-1} = e^{-j\omega T_A} = \cos \omega T_A - \sin \omega T_A \qquad (7)$$

ergibt sich der Amplitudengang des Integrierglieds zu

$$G_{\text{int}}(j\omega) = 1 + \cos \omega T_A - j \sin \omega T_A$$
$$|G_{\text{int}}(j\omega)| = \sqrt{2 + 2\cos \omega T_A} = \sqrt{2 + 2\cos \frac{2\pi f}{f_A}} \qquad (8)$$

Hierbei steht f für die Netzfrequenz und $f_A$ für die Abtastfrequenz bei der Signalerfassung. Der Skalierungsfaktor $F_{\text{int}}$ des Integrierglieds ist das Reziproke des Amplitudengangs. Damit ergibt sich für den Skalierungsfaktor $F_{\text{int}}$ bei einer angenommenen Netzfrequenz von 50Hz und einer Abtastfrequenz von 1000Hz ein Wert von etwa 0,05.

Die Übertragungsfunktion $\hat{G}_{dif}$ des Differenzierglieds (bzw. des Differenzenquotienten) in diskreter Schreibweise kann als nichtrekursiver Hochpass mit $a_0 = 1$ und $a_1 = -1$ angesehen werden:

$$\hat{G}_{dif}(z) = a_0 + a_1 z^{-1} \qquad (9)$$

Mit der Beziehung (7) ergibt sich der Amplitudengang des Differenzierglieds zu

$$G_{\text{int}}(j\omega) = 1 - \cos\omega T_A + j\sin\omega T_A$$

$$\left|G_{\text{int}}(j\omega)\right| = \sqrt{2 - 2\cos\omega T_A} = \sqrt{2 - 2\cos\frac{2\pi f}{f_A}} \qquad (10)$$

Der Skalierungsfaktor $F_{dif}$ des Differenzierglieds ist das Reziproke des Amplitudengangs. Damit ergibt sich für den Skalierungsfaktor $F_{dif}$ bei einer angenommenen Netzfrequenz von 50Hz und einer Abtastfrequenz von 1000Hz ein Wert von etwa 3,196.

Wenn mit die Abtastfrequenz in geeigneter Weise der Netzfrequenz nachgeführt wird, bleiben die Skalierungsfaktoren $F_{int}$ und $F_{dif}$ konstant.

Gemäß einer weiteren vorteilhaften Ausführungsform ist vorgesehen, dass die Abgabe eines Fehlersignals blockiert wird, wenn eine vorgegebene Anzahl aufeinanderfolgender Messwertpaare in einem vorgegebenen Stabilisierungsbereich liegt.

Durch das Vorsehen eines gesonderten Stabilisierungsbereichs innerhalb des Auslösediagramms kann vergleichsweise einfach und mit hoher Selektivität anhand der Lage der Messwertpaare der jeweiligen abgeschätzten Werte auf das Vorliegen eines internen oder externen Fehlers geschlossen werden. Liegen z.B. zwei aufeinanderfolgende Messwertpaare innerhalb des gesonderten Stabilisierungsbereiches, so wird dies als Zeichen für das Vorliegen eines externen Fehlers gewertet und entsprechend die Abgabe eines Fehlersignals - zumindest temporär - blockiert.

Um die Sicherheit einer Auslösung im Falle eines internen Fehlers weiter zu erhöhen, wird gemäß einer weiteren vorteilhaften Ausführungsform des erfindungsgemäßen Verfahrens vorgeschlagen, dass die abgeschätzten Differenzstromwerte auch mit einem Differenzstromschwellenwert verglichen werden und das Fehlersignal auch erzeugt wird, wenn eine vorgegebene Anzahl aufeinanderfolgender abgeschätzter Differenzstromwerte den Differenzstromschwellenwert überschreitet.

Auf diese Weise wird quasi parallel zur Auslösebereichsprüfung eine Prüfung der Größe der abgeschätzten Differenzstromwerte durch Vergleich mit einem Differenzstromschwellenwert durchgeführt und z.B. bei zwei aufeinanderfolgenden, besonders hohen (d.h. über dem Schwellenwert liegenden) abgeschätzten Differenzstromwerten unabhängig von der Lage des Messwertpaares auf einen internen Fehler geschlossen. Hierdurch kann in besonders eindeutigen Fällen mit hohen abgeschätzten Differenzstromwerten ein Fehlersignal besonders schnell erzeugt werden.

Die Erfindung bezieht sich darüber hinaus auf ein elektrisches Schutzgerät gemäß Anspruch 7 zur Bildung eines Fehlersignals mit Anschlüssen zum unmittelbaren oder mittelbaren Anschluss an zumindest zwei unterschiedlichen Messstellen einer Komponente, und mit einer Auswerteinrichtung, die dazu eingerichtet ist, mit Strommesswerten Differenzstromwerte und Stabilisierungswerte zu bilden und ein Fehlersignal zu erzeugen, wenn ein unter Heranziehung eines der Differenzstromwerte und dem jeweils zugehörigen Stabilisierungswert gebildetes Messwertpaar in einem vorgegebenen Auslösebereich liegt.

Erfindungsgemäß ist bezüglich des elektrischen Schutzgeräts vorgesehen, dass die Auswerteinrichtung dazu eingerichtet ist, aus aufeinanderfolgenden, auf Grundlage während eines sättigungsfreien Zustands der Stromwandler zu Beginn eines Fehlers erfasster Strommesswerte gebildeten Differenzstromwerten und zugehörigen Stabilisierungswerten abgeschätzte Differenzstromwerte und zugehörige abgeschätzte Stabilisierungswerte zu bilden, mit denen zumindest ein Wert eines erwarteten zukünftigen Verlaufs der Differenzstromwerte und der Stabilisierungsstromwerte abgeschätzt wird, und für die Auslösebereichsprüfung die Lage eines aus einem abgeschätzten Differenzstromwert und dem jeweils zugehörigen abgeschätzten Stabilisierungswert gebildeten Messwertpaares auszuwerten.

Gemäß einer vorteilhaften Ausführungsform des erfindungsgemäßen Schutzgeräts ist vorgesehen, dass die Auswerteinrichtung dazu eingerichtet ist, die Abgabe eines Fehlersignals zu blockieren, wenn eine vorgegebene Anzahl aufeinanderfolgender Messwertpaare in einem vorgegebenen Stabilisierungsbereich liegt.

Eine weitere vorteilhafte Ausführungsform des erfindungsgemäßen Schutzgeräts sieht zudem vor, dass die Auswerteinrichtung dazu eingerichtet ist, die abgeschätzten Differenzstromwerte auch mit einem Differenzstromschwellenwert zu vergleichen und das Fehlersignal auch dann zu erzeugen, wenn eine vorgegebene Anzahl aufeinanderfolgender abgeschätzter Differenzstromwerte den Differenzstromschwellenwert überschreitet.

Bezüglich der Vorteile des erfindungsgemäßen Schutzgeräts sei auf die obigen Ausführungen im Zusammenhang mit dem erfindungsgemäßen Verfahren verwiesen, da sich die Vorteile des erfindungsgemäßen Schutzgeräts und die des erfindungsgemäßen Verfahrens im Wesentlichen entsprechen.

Die Erfindung wird nachfolgend anhand von Ausführungsbeispielen näher erläutert; dabei zeigen beispielhaft:

Figur 1    eine Anordnung mit einem Ausführungsbeispiel für ein erfindungsgemäßes Schutzgerät;

Figur 2    ein erstes Strom-Zeit-Diagramm zur Erläuterung des Einflusses der Wandlersättigung auf die Ermittlung eines Differenzstroms bei einem externen Fehler;

Figur 3     ein erstes Auslösediagramm mit einer Auslösekennlinie, die innerhalb des Auslösediagramms einen Auslösebereich von einem "Nichtauslösebereich" trennt;

Figur 4     ein schematisches Blockschaltbild einer Auswerteinrichtung zur detaillierten Erläuterung der Funktionsweise eines Ausführungsbeispiels eines erfindungsgemäßen Schutzgerätes;

Figur 5     ein zweites Auslösediagramm zur Erläuterung des Effektes des erfinderischen Verfahrens auf die Möglichkeit zur Unterscheidung interner und externer Fehler.

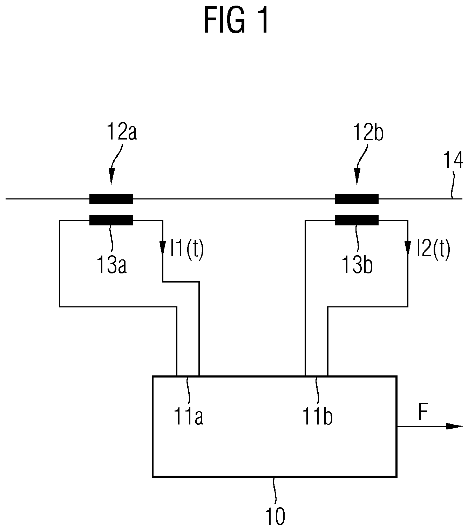

In den Figuren 1 - 5 werden aus Gründen der Übersicht für identische oder vergleichbare Komponenten stets dieselben Bezugszeichen verwendet.

In der Figur 1 erkennt man eine Anordnung mit einem Ausführungsbeispiel eines Schutzgerätes 10 mit zwei Anschlüssen 11a und 11b zum Anschluss an zwei Messstellen 12a und 12b. Die beiden Messstellen 12a, 12b sind durch zwei Stromwandler 13a und 13b gebildet, die an einen Phasenleiter 14 einer nicht weiter dargestellten überwachten Komponente eines Energieversorgungsnetzes, beispielsweise in Form einer Energieversorgungsleitung, angeschlossen sind.

Die beiden Stromwandler 13a und 13b erzeugen ausgangsseitig Stromsignale I1(t) und I2(t), die den Stromverlauf an den beiden Messstellen 12a, 12b wiedergeben. Das Schutzgerät 10 erfasst diese Stromsignale, ermittelt daraus durch Abtastung Strommesswerte und überprüft diese Strommesswerte daraufhin, ob sie auf das Vorliegen eines fehlerhaften Betriebszustands, z.B. eines internen Kurzschlusses, der Komponente hinweisen, und erzeugt ggf. ausgangsseitig ein Fehlersignal F, wenn ein solcher fehlerhafter Betriebszustand festgestellt wurde. Das Fehlersignal F dient dazu, in der Figur 1 nicht dargestellte, die Komponente begrenzende Schalteinrichtungen, z.B. Leistungsschalter, zum Öffnen ihrer Schaltkontakte zu veranlassen, um den Fehler aus dem restlichen Energieversorgungsnetz abzutrennen.

Ein Schutzgerät gemäß dem Stand der Technik bildet hierzu aus zusammengehörenden, d.h. gleichzeitig erfassten, Strommesswerten Differenzstromwerte und zugehörige Stabilisierungswerte und prüft die Lage eines aus einem Differenzstromwert und einem Stabilisierungswert bestehenden Messwertpaares in einem Auslösediagramm. Liegt das Messwertpaar innerhalb eines Auslösebereichs, wird auf einen internen Fehler geschlossen und das Fehlersignal erzeugt.

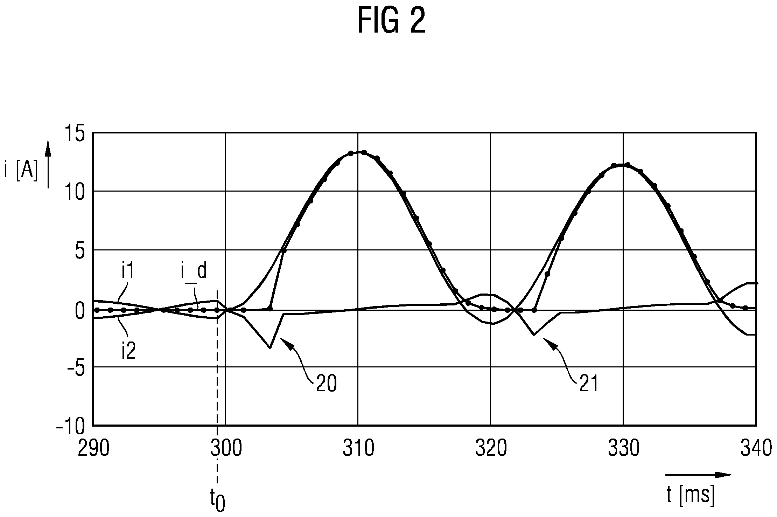

In Figur 2 ist ein Strom-Zeit-Diagramm dargestellt, in dem ein von einem ersten Stromwandler ausgangsseitig abgegebenes Stromsignal i1, ein von einem zweiten Stromwandler abgegebenes Stromsignal i2 und der Verlauf von aus entsprechenden Strommesswerten gebildeten Differenzstromwerten i_d gezeigt sind. Zum Zeitpunkt $t_0$ tritt ein stromstarker externer Fehler, d.h. ein Fehler außerhalb der überwachten Komponente, auf, der daher zu keiner Auslösung des Schutzgeräts führen sollte. Während der erste Stromwandler keine Sättigungseffekte aufzeigt, ist das von dem zweiten Stromwandler abgegebene Stromsignal i2 durch Sättigungseffekte beeinträchtigt; diese Sättigungseffekte sind beispielsweise in den Bereichen 20 und 21 erkennbar. Deutlich erkennbar ist, dass der gebildete Verlauf der Differenzstromwerte i_d mit Eintreten der Stromwandlersättigung im Bereich 20 keine verlässliche Aussage über den Betriebszustand der überwachten Komponente mehr zulässt, da aufgrund des durch die Stromwandlersättigung verfälschten Stromsignals i2 nunmehr trotz des externen Fehlers ein signifikanter Differenzstrom auftritt, der nahezu den Wert des Stromsignals i1 annimmt.

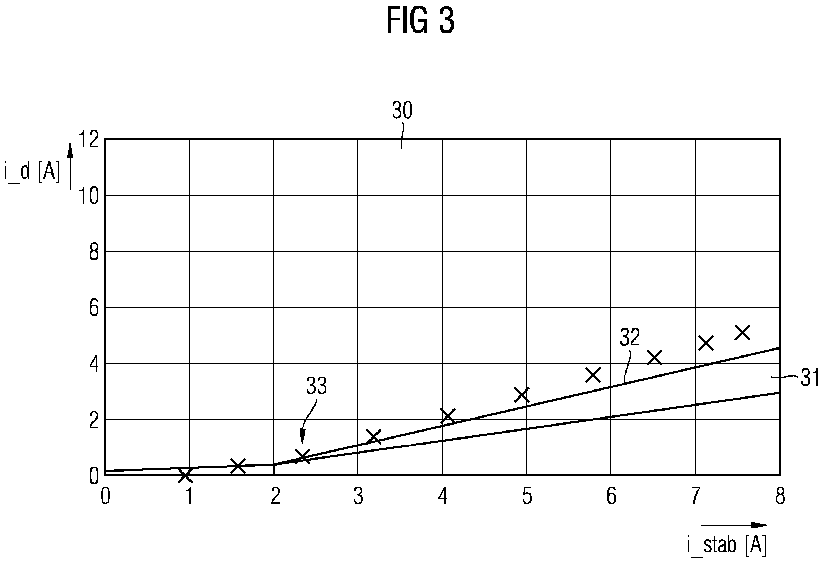

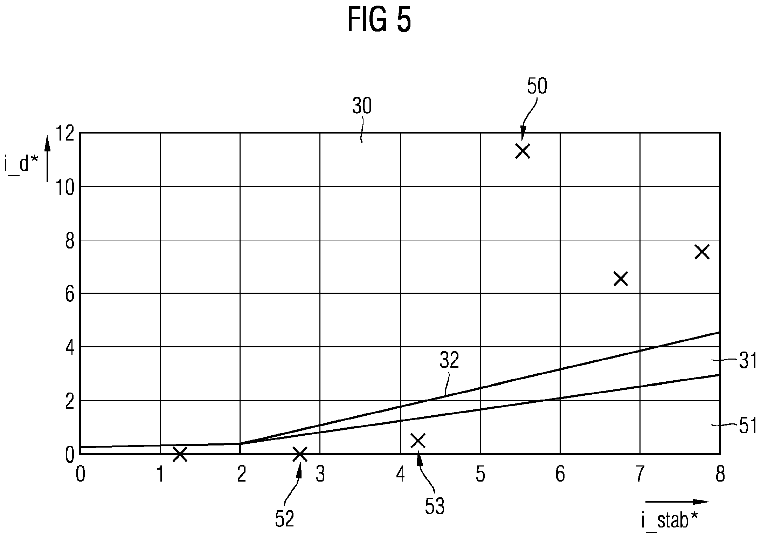

In Figur 3 ist beispielhaft ein Auslösediagramm dargestellt, in das durch Stromwandlersättigung beeinflusste Messwertpaare der Differenzstromwerte i_d und Stabilisierungswerte i_stab als Kreuze eingetragen sind. Das Auslösediagramm weist einen Auslösebereich 30 auf der durch eine Auslösekennlinie 32 von einem Normalbereich 31 abgetrennt ist. Innerhalb des Normalbereichs ist zur zusätzlichen Stabilisierung ein Stabilisierungsbereich eingetragen, dessen Funktionsweise im Zusammenhang mit Figur 5 näher erläutert wird. Man erkennt, dass ab Eintreten der Wandlersättigung, die sich erstmals auf das Messwertpaar 33 auswirkt, die Messwertpaare trotz Vorliegen eines externen Fehlers im Auslösebereich 30 liegen, was fälschlicher zur Bildung eines Fehlersignals führen würde. Entsprechend kann sich eine vorliegende Stromwandlersättigung bei einem internen Fehler derart auswirken, dass fälschlicherweise auf einen externen Fehler erkannt wird und folglich kein Fehlersignal erzeugt wird.

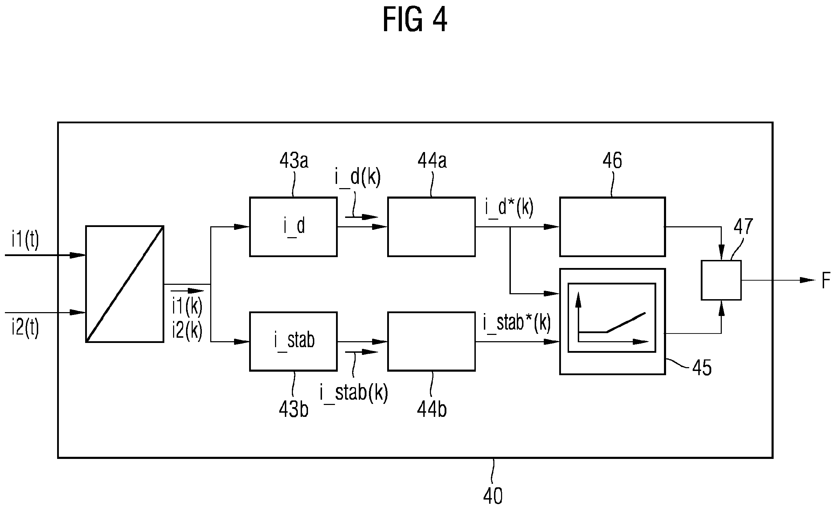

Zur Vermeidung von Fehlentscheidungen aufgrund des Auftretens von Wandlersättigung weist ein erfindungsgemäßes Schutzgerät eine Auswerteinrichtung auf, die beispielsweise entsprechend dem in Figur 4 dargestellten Ausführungsbeispiel ausgebildet ist. Figur 4 zeigt eine Auswerteinrichtung 40 eines Schutzgeräts. Die nachfolgend beschriebenen Komponenten der Auswerteinrichtung können beispielsweise in Form einer Steuersoftware implementiert sein oder durch als Elektronikschaltungen ausgeführte Hardwarebausteine gebildet sein.

Einem Messwerteingang 41 der Auswerteinrichtung 40 werden die Stromsignale il(t) und i2(t) zugeführt und mittels einer Abtasteinrichtung 42 in Strommesswerte i1(k) und i2(k) umgesetzt. Diese Strommesswerte i1(k) und i2(k) werden von der Abtasteinrichtung 42 ausgangsseitig abgegeben und einem ersten Block 43a zur Bildung eines Differenzstromwertes i_d(k) und einem zweiten Block 43b zur Bildung eines Stabilisierungswertes i_stab(k) zugeführt. Hierzu bildet der erste Block 43a den Betrag der vorzeichenrichtigen Summe der Strommesswerte i1(k) und i2(k):

$$i\_d(k) = |i1(k)+ i2(k)|.$$

Da in die Komponente hinein und aus ihr heraus fließende Ströme hinsichtlich ihres Vorzeichens unterschiedlich behandelt werden, ergibt sich im fehlerfreien Fall, in dem i1(k) und i2(k) betragsmäßig gleich groß sind, ein Differenzstromwert i_d(k) gleich (oder nahe) Null.

Der zweite Block 43b bildet einen jeweiligen Stabilisierungswert i_stab(k) in komponentenspezifischer Weise; im Falle einer Energieübertragungsleitung wie in Figur 1 angenommen wird der Stabilisierungswert i_stab(k) durch Addition der Beträge der Strommesswerte aller Messstellen (hier also der beiden Messstellen 12a und 12b) gebildet:

$$i\_stab(k) = |i1(k)| + |i2(k)|.$$

Der jeweilige Differenzstromwert i_d(k) bzw. Stabilisierungswert i_stab(k) werden von den Blöcken 43a und 43b ausgangsseitig abgegeben.

Der Differenzstromwert i_d(k) wird daraufhin einem ersten Schätzer-Block 44a zur Bildung eines abgeschätzten Differenzstromwertes i_d*(k) zugeführt. Der abgeschätzte Differenzstromwert gibt hierbei zumindest einen Wert eines erwarteten zukünftigen Verlaufs der Differenzstromwerte an und kann beispielsweise wie zuvor bereits erläutert als Amplitude des Verlaufs der Differenzstromwerte aus dem aktuellen Differenzstromwert i_d(k) und einem unmittelbar zuvor gebildeten Differenzstromwert i_d(k-1) gebildet werden.

In entsprechender Weise wird der Stabilisierungswert i_stab(k) einem zweiten Schätzer-Block 44b zur Bildung eines abgeschätzten Stabilisierungswertes i_stab*(k) zugeführt. Der abgeschätzte Stabilisierungswert gibt hierbei zumindest einen Wert eines erwarteten zukünftigen Verlaufs der Stabilisierungswerte an und kann beispielsweise wie zuvor bereits erläutert als Amplitude des Verlaufs der Stabilisierungswerte aus dem aktuellen Stabilisierungswert i_stab(k) und einem unmittelbar zuvor gebildeten Stabilisierungswert i_stab(k-1) gebildet werden.

Sowohl der abgeschätzte Differenzstromwert i_d*(k) als auch der zugehörige abgeschätzte Stabilisierungswert i_stab*(k) werden einem Prüfblock 45 zugeführt, der eine Prüfung der Lage eines aus diesen Werten gebildeten Messwertpaares in einem Auslösediagramm vornimmt. Liegt das Messwertpaar innerhalb des Auslösebereichs, wird das Fehlersignal F erzeugt. Liegt das Messwertpaar hingegen innerhalb des Normalbereichs, so wird die Ausgabe eines Fehlersignals blockiert.

Hierzu zeigt Figur 5 ein prinzipiell mit dem Diagramm gemäß Figur 3 vergleichbares Auslösediagramm, in dem Messwertpaare aus abgeschätzten Differenzstromwerten i_d* und zugehörigen abgeschätzten Stabilisierungswerten i_stab* für den Fall eines externen Fehlers mit auftretender Wandlersättigung eingetragen sind. Aufgrund der Tatsache, dass die jeweiligen abgeschätzten Werte lediglich auf zwei Strommesswerten beruhen und damit frühzeitig nach Fehlereintritt - und somit in der sättigungsfreien Zeit der Stromwandler - ermittelt werden können, zeigt sich der in Figur 5 dargestellte Verlauf der Messwertpaare. Die auftretende Wandlersättigung macht sich erst ab dem Messwertpaar 50 bemerkbar; die beiden davor gebildeten Messwertpaare 52 und 53 liegen hingegen innerhalb des in dem Normalbereich 31 vorgesehenen Stabilisierungsbereichs 51, der auf das Vorliegen einer Wandlersättigung hindeutet. Der Schutzalgorithmus des Schutzgerätes kann bezüglich der Behandlung dieses Stabilisierungsbereichs 51 derart eingestellt sein, dass eine Abgabe eines Fehlersignals F blockiert wird, wenn eine vorgegebene Anzahl von Messwertpaaren innerhalb des Stabilisierungsbereichs vorliegt. Im in Figur 5 dargestellten Fall ist der entsprechende Parameter bei einem Wert von 2 zu wählen, damit die beiden in dem Stabilisierungsbereich liegenden Messwertpaare 52, 53 eine (temporäre) Blockierung der Abgabe eines Fehlersignals auslösen, so dass trotz der folgenden innerhalb des Auslösebereichs 30 liegenden Messwertpaare kein Fehlersignal F erzeugt wird.

Zusätzlich zu der bisher beschriebenen Funktionsweise zur Bildung des Fehlersignals F kann die Auswerteinrichtung 40 gemäß Figur 4 auch einen weiteren Prüfblock 46 aufweisen, dem eingangsseitig die abgeschätzten Differenzstromwerte i_d*(k) zugeführt werden. Der Prüfblock 46 vergleicht die abgeschätzten Differenzstromwerte i_d*(k) mit einem vorgegebenen Differenzstromschwellenwert und gibt ausgangsseitig ein Signal ab, wenn eine vorgegebene Anzahl (z.B. 2) von abgeschätzten Differenzstromwerten über dem Differenzstromschwellenwert liegt. In diesem Fall ist den beiden Prüfblöcken 45 und 46 ein ODER-Glied 47 nachgeordnet, das ausgangsseitig das Fehlersignals F dann ausgibt, wenn entweder der erste Prüfblock 45 oder der zweite Prüfblock (oder beide Prüfblöcke) einen internen Fehler erkennen und entsprechend ein Signal abgeben.

**Patentansprüche**

1. Differentialschutzverfahren zum Erzeugen eines Fehlersignals (F), bei dem

   - mit Stromwandlern an mindestens zwei unterschiedlichen Messstellen (12a, 12b) einer Komponente jeweils Strommesswerte gemessen werden,
   - mit den Strommesswerten Differenzstromwerte und Stabilisierungswerte gebildet werden, und
   - das Fehlersignal (F) erzeugt wird, wenn im Rahmen einer Auslösebereichsprüfung festgestellt wird, dass ein unter Heranziehung eines der Differenzstromwerte und dem jeweils zugehörigen Stabilisierungswert gebildetes Messwertpaar in einem vorgegebenen Auslösebereich (30) liegt,

   **dadurch gekennzeichnet, dass**

   - mindestens ein Teil der Differenzstromwerte und der Stabilisierungswerte mit während eines sättigungsfreien Zustands der Stromwandler zu Beginn eines Fehlers erfassten Strommesswerten gebildet werden,
   - aus aufeinanderfolgenden, auf Grundlage während eines sättigungsfreien Zustands der Stromwandler zu Beginn eines Fehlers erfasster Strommesswerte gebildeten Differenzstromwerten und zugehörigen Stabilisierungswerten abgeschätzte Differenzstromwerte und zugehörige abgeschätzte Stabilisierungswerte gebildet werden, mit denen zumindest ein Wert eines erwarteten zukünftigen Verlaufs der Differenzstromwerte und der Stabilisierungsstromwerte abgeschätzt wird, und
   - für die Auslösebereichsprüfung die Lage eines aus einem abgeschätzten Differenzstromwert und dem jeweils zugehörigen abgeschätzten Stabilisierungswert gebildeten Messwertpaares ausgewertet wird.

2. Verfahren nach Anspruch 1,
   **dadurch gekennzeichnet, dass**

   - zur Bildung eines jeweiligen abgeschätzten Differenzstromwertes jeweils der aktuelle Differenzstromwert und der diesem unmittelbar vorangehende Differenzstromwert und
   - zur Bildung eines jeweiligen abgeschätzten Stabilisierungswertes jeweils der aktuelle Stabilisierungswert und der diesem unmittelbar vorangehende Stabilisierungswert verwendet werden.

3. Verfahren nach Anspruch 2,
   **dadurch gekennzeichnet, dass**

   - die jeweiligen abgeschätzten Werte eine Amplitude des erwarteten zukünftigen Verlaufs der Differenzstromwerte und eine Amplitude des erwarteten zukünftigen Verlaufs der Stabilisierungswerte angeben.

4. Verfahren nach Anspruch 3,
   **dadurch gekennzeichnet, dass**

   - der jeweilige abgeschätzte Differenzstromwert und der jeweilige abgeschätzte Stabilisierungswert jeweils unter Verwendung eines ersten, mittels eines Integriergliedes gebildeten Schätzwertanteils und eines zweiten, mittels eines Differenziergliedes gebildeten Schätzwertanteils gebildet werden.

5. Verfahren nach einem der vorangehenden Ansprüche,
   **dadurch gekennzeichnet, dass**

   - die Abgabe des Fehlersignals (F) blockiert wird, wenn eine vorgegebene Anzahl aufeinanderfolgender Messwertpaare in einem vorgegebenen Stabilisierungsbereich (51) liegt.

6. Verfahren nach einem der vorangehenden Ansprüche,
   **dadurch gekennzeichnet, dass**

   - die abgeschätzten Differenzstromwerte auch mit einem Differenzstromschwellenwert verglichen werden und
   - das Fehlersignal (F) auch erzeugt wird, wenn eine vorgegebene Anzahl aufeinanderfolgender abgeschätzter Differenzstromwerte den Differenzstromschwellenwert überschreitet.

7. Elektrisches Schutzgerät (10) zur Bildung eines Fehlersignals (F)

- mit Anschlüssen (11a, 11b) zum unmittelbaren oder mittelbaren Anschluss an zumindest zwei unterschiedlichen Messstellen (12a, 12b) einer Komponente, und
- mit einer Auswerteinrichtung (40), die dazu eingerichtet ist, mit mittels Stromwandlern erfassten Strommesswerten Differenzstromwerte und Stabilisierungswerte zu bilden und ein Fehlersignal (F) zu erzeugen, wenn ein unter Heranziehung eines der Differenzstromwerte und dem jeweils zugehörigen Stabilisierungswert gebildetes Messwertpaar in einem vorgegebenen Auslösebereich (30) liegt,

**dadurch gekennzeichnet, dass**

- die Auswerteinrichtung dazu eingerichtet ist, aus aufeinanderfolgenden, auf Grundlage während eines sättigungsfreien Zustands der Stromwandler zu Beginn eines Fehlers erfasster Strommesswerte gebildeten Differenzstromwerten und zugehörigen Stabilisierungswerten abgeschätzte Differenzstromwerte und zugehörige abgeschätzte Stabilisierungswerte zu bilden, mit denen zumindest ein Wert eines erwarteten zukünftigen Verlaufs der Differenzstromwerte und der Stabilisierungsstromwerte abgeschätzt wird, und für die Auslösebereichsprüfung die Lage eines aus einem abgeschätzten Differenzstromwert und dem jeweils zugehörigen abgeschätzten Stabilisierungswert gebildeten Messwertpaares auszuwerten.

8. Elektrisches Schutzgerät (10) nach Anspruch 7,
**dadurch gekennzeichnet, dass**

- die Auswerteinrichtung (40) dazu eingerichtet ist, die Abgabe des Fehlersignals (F) zu blockieren, wenn eine vorgegebene Anzahl aufeinanderfolgender Messwertpaare in einem vorgegebenen Stabilisierungsbereich (51) liegt.

9. Elektrisches Schutzgerät (10) nach der Ansprüche 7 oder 8,
**dadurch gekennzeichnet, dass**

- die Auswerteinrichtung (40) dazu eingerichtet ist, die abgeschätzten Differenzstromwerte auch mit einem Differenzstromschwellenwert zu vergleichen und das Fehlersignal (F) auch dann zu erzeugen, wenn eine vorgegebene Anzahl aufeinanderfolgender abgeschätzter Differenzstromwerte den Differenzstromschwellenwert überschreitet.

**Claims**

1. Differential protection method for generating a fault signal (F), wherein

- current measurement values are in each case measured at at least two different measurement locations (12a, 12b) of a component using current transformers,
- differential current values and stabilization values are formed using the current measurement values, and
- the fault signal (F) is generated if, in the context of a tripping range test, it is established that a measurement value pair formed using one of the differential current values and the respectively associated stabilization value lies in a predefined tripping range (30),

**characterized in that**

- at least some of the differential current values and the stabilization values are formed using current measurement values recorded during a saturation-free state of the current transformers at the beginning of a fault,
- from successive differential current values, formed on the basis of current measurement values recorded during a saturation-free state of the current transformers at the beginning of a fault, and associated stabilization values, estimated differential current values and associated estimated stabilization values are formed, which are used to estimate at least one value of an expected future profile of the differential current values and the stabilization current values, and
- the position of a measurement value pair formed from an estimated differential current value and the respectively associated estimated stabilization value is evaluated for the tripping range test.

2. Method according to Claim 1,
**characterized in that**

- in each case the present differential current value and the differential current value directly preceding the latter are used for forming a respective estimated differential current value, and
- in each case the present stabilization value and the stabilization value directly preceding the latter are used for forming a respective estimated stabilization value.

3. Method according to Claim 2,
**characterized in that**

- the respective estimated values indicate an amplitude of the expected future profile of the differential current values and an amplitude of the expected future profile of the stabilization values.

4. Method according to Claim 3,
**characterized in that**

- the respective estimated differential current value and the respective estimated stabilization value are formed in each case using a first estimated value portion formed by means of an integrating element and a second estimated value portion formed by means of a differentiating element.

5. Method according to one of the preceding claims,
**characterized in that**

- the outputting of the fault signal (F) is blocked if a predefined number of successive measurement value pairs lie in a predefined stabilization range (51).

6. Method according to one of the preceding claims,
**characterized in that**

- the estimated differential current values are also compared with a differential current threshold value and
- the fault signal (F) is also generated if a predefined number of successive estimated differential current values exceed the differential current threshold value.

7. Electrical protective apparatus (10) for forming a fault signal (F)

- comprising connections (11a, 11b) for direct or indirect connection to at least two different measurement locations (12a, 12b) of a component, and
- comprising an evaluation device (40) designed to form differential current values and stabilization values using current measurement values recorded by means of current transformers and to generate a fault signal (F) if a measurement value pair formed using one of the differential current values and the respectively associated stabilization value lies in a predefined tripping range (30),

**characterized in that**

- the evaluation device is designed to form, from successive differential current values, formed on the basis of current measurement values recorded during a saturation-free state of the current transformers at the beginning of a fault, and associated stabilization values, estimated differential current values and associated estimated stabilization values, which are used to estimate at least one value of an expected future profile of the differential current values and the stabilization current values, and is designed to evaluate the position of a measurement value pair formed from an estimated differential current value and the respectively associated estimated stabilization value for the tripping range test.

8. Electrical protective apparatus (10) according to Claim 7,
**characterized in that**

- the evaluation device (40) is designed to block the outputting of the fault signal (F) if a predefined number of successive measurement value pairs lie in a predefined stabilization range (51).

9. Electrical protective apparatus (10) according to either of Claims 7 and 8,
**characterized in that**

- the evaluation device (40) is designed also to compare the estimated differential current values with a differential current threshold value and also to generate the fault signal (F) if a predefined number of successive estimated differential current values exceed the differential current threshold value.

**Revendications**

1. Procédé de protection différentielle pour produire un signal (F) de défaut, dans lequel

- on mesure respectivement des valeurs de mesure de courant par des transformateurs de courant en au moins deux points (12a, 12b) de mesure différents d 'un élément,
- on forme par les valeurs de mesure du courant des valeurs de courant de différence et des valeurs de stabilisation et
- on produit le signal (F) de défaut si l 'on constate, dans le cadre d 'un contrôle par domaine de déclenchement, qu'une paire de valeurs de mesure, formée en tirant parti de l 'une des valeurs de courant de différence et de la valeur de stabilisation associée respectivement, se trouve dans un domaine (30) de déclenchement donné à l'avance,

**caractérisé en ce que**

- on forme au moins une partie des valeurs de courant de différence et des valeurs de stabilisation par des valeurs de mesure de courant relevées pendant un état sans saturation du transformateur de courant au début d 'un défaut,
- on forme à partir de valeurs de courant de différence et de valeurs de stabilisation associées successives, formées sur la base de valeurs de mesure de courant relevées au début d 'un défaut pendant un état sans saturation du transformateur de courant, des valeurs de courant de différence estimées et des valeurs de stabilisation associées estimées, par lesquelles on estime au moins une valeur d 'une courbe à venir escomptée des valeurs de courant de différence et des valeurs de courant de stabilisation, et
- pour le contrôle du domaine de déclenchement, on exploite la position d 'une paire de valeurs de mesure formée à partir d'une valeur de courant de différence estimée et de la valeur de stabilisation estimée associée respectivement.

2. Procédé suivant la revendication 1,
**caractérisé en ce que**

- pour la formation d'une valeur de courant de différence estimée respective, on utilise respectivement la valeur de courant de différence en cours et la valeur de courant de différence immédiatement précédente de celle -ci et
- pour la formation d'une valeur de stabilisation estimée respective, on utilise respectivement la valeur de stabilisation en cours et la valeur de stabilisation immédiatement précédente de celle -ci.

3. Procédé suivant la revendication 2, **caractérisé en ce que**

- les valeurs estimées respectives indiquent une amplitude de la courbe à venir escomptée des valeurs de courant de différence et une amplitude de la courbe à venir escomptée des valeurs de stabilisation.

4. Procédé suivant la revendication 3, **caractérisé en ce que**

- on forme la valeur de courant de différence estimée respectivement et la valeur de stabilisation estimée respectivement, en utilisant une première proportion de valeurs d 'estimation formée au moyen d'un élément d 'intégration et une deuxième proportion de valeurs d 'estimation formée au moyen d'un élément de différenciation

5. Procédé suivant l 'une des revendications précédentes,
**caractérisé en ce que**

- on bloque l'émission du signal (F) de défaut, si un nombre donné à l'avance de paires de valeurs de mesure successives, se trouve dans un domaine (51) de stabilisation donné à l 'avance.

**6.** Procédé suivant l'une des revendications précédentes
**caractérisé en ce que**

- on compare les valeurs de courant de différence estimées également à une valeur de seuil de courant de différence et
- on produit également le signal (F) de défaut, si un nombre donné à l'avance de valeurs de courant de différence estimées successive dépasse la valeur de seuil de courant de différence.

**7.** Appareil (10) de protection électrique pour la formation d'un signal (F) de défaut

- comprenant des bornes (11a, 11b) de connexion directe ou indirecte à au moins deux points (12a, 12b) de mesure différents d'un élément et
- comprenant un dispositif (40) d'exploitation, qui est conçu pour former, par des valeurs de mesure de courant relevées au moyen de transformateurs de courant, des valeurs de courant de différence et des valeurs de stabilisation et pour produire un signal (F) de défaut, si une paire de valeurs de mesure formée en tirant parti de l'une des valeurs de courant de différence et de la valeur de stabilisation associée respectivement se trouve dans un domaine (30) de déclenchement donné à l'avance,

**caractérisé en ce que**

- le dispositif d'exploitation est conçu pour former, à partir de valeurs de courant de différence et de valeurs de stabilisation associées successives formées sur la base de valeurs de mesure de courant relevées au début d'un défaut pendant un état sans saturation du transformateur de courant, des valeurs de courant de différence estimées et des valeurs de stabilisation associées estimées, par lesquelles on estime au moins une valeur d'une courbe à venir escomptée des valeurs de courant de différence et des valeurs de courant de stabilisation et, pour le contrôle du domaine de déclenchement, pour exploiter la position d'une paire de valeurs de mesure formée à partir d'une valeur de courant de différence estimée et de la valeur de stabilisation estimée associée respectivement.

**8.** Appareil (10) de protection électrique suivant la revendication 7,
**caractérisé en ce que**

- le dispositif (40) d'exploitation est conçu pour bloquer l'émission du signal (F) de défaut, si un nombre donné à l'avance de paires de valeurs de mesure successives se trouve dans un domaine (51) de stabilisation donné à l'avance.

**9.** Appareil (10) de protection électrique suivant la revendication 7 et 8, **caractérisé en ce que**

- le dispositif (40) d'exploitation est conçu pour comparer les valeurs de courant de différence estimées également à une valeur de seuil de courant de différence et pour produire également le signal (F) de défaut, si un nombre donné à l'avance de valeurs de courant de différences estimées successives dépasse la valeur de seuil de courant de différence.

# FIG 1

FIG 2

FIG 3

EP 2 901 534 B1

# FIG 4

FIG 5

EP 2 901 534 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008025309 A1
- DE 2339931 A1
- US 4623949 A